Europäisches Patentamt

European Patent Office

Office européen des brevets

(19)

(11) Publication number : **0 501 783 A2**

## (12) EUROPEAN PATENT APPLICATION

(21) Application number : 92301630.7

(22) Date of filing : 26.02.92

(51) Int. Cl.⁵ : **H04M 9/08**

(30) Priority : **28.02.91 US 662148**

(43) Date of publication of application :
**02.09.92 Bulletin 92/36**

(84) Designated Contracting States :
**DE FR GB**

(71) Applicant : **MOTOROLA, INC.**
**1303 East Algonquin Road**
**Schaumburg, IL 60196 (US)**

(72) Inventor : **Bader, Scott K.**
**908 W Los Lagos Vista**
**Mesa, Arizona 85210 (US)**
Inventor : **Takeshian, Tony**
**3175 W Price Road No. 2075**
**Chandler, Arizona 85224 (US)**
Inventor : **Gomez, Michael L.**
**1201 S. McClintock No. 212**
**Tempe, Arizona 85281 (US)**

(74) Representative : **Dunlop, Hugh Christopher et al**
**Motorola European Intellectual Property**
**Operations Jays Close Viables Industrial**
**Estate**
**Basingstoke, Hampshire RG22 4PD (GB)**

(54) Speakerphone with serial port interface.

(57) A speakerphone with a serial port interface (64) is provided for interfacing a typical speakerphone to a microprocessor. The serial port interface allows the speakerphone to receive input data in a serial fashion thereby minimizing the number of external pins required. Further, since the input data is received serially, increased programmability of the speakerphone is also achieved without increasing the number of external pins.

FIG. 1

EP 0 501 783 A2

## Background of the Invention

The present invention relates to interfaces, for example, a serial port interface for a speakerphone system.

Current half duplex speakerphones include complementary attenuators to control the gain in the receive and transmit paths. The gain of each path is determined by the relative strength of the signal appearing in each path. Further, a variety of functions (modes) are typically included in a speakerphone such as receive mute, transmit mute, volume control, etc. These functions are determined by external, parallel data signals which are input to the speakerphone and subsequently decoded by some simple analog decode logic circuitry, such as, $I^2L$ logic circuitry.

However, the versatility of the number of modes in a speakerphone is typically limited by the number of pins required by the parallel input signals in order to select and perform the various modes. For example, given N-data input pins, $2^N$ possible modes are obtained. Thus, interfacing a microprocessor to a speakerphone having parallel input signals is cumbersome and parts intensive especially as the number of desired modes increase.

Hence, a need exists for a serial port interface which interfaces a microprocessor to a speakerphone thereby allowing for an increased number of modes while utilizing a minimum of input pins.

## Summary of the Invention

Briefly, there is provided a serial port interface for a speakerphone comprising a plurality of serially coupled flip-flop latches having a data input coupled to receive a data logic signal and having a plurality of outputs for providing a plurality of output logic signals to the speakerphone, the data logic signal being shifted into ones of the plurality of serially coupled flip flop latches in response to a first control signal and subsequently appearing at the plurality of outputs of the plurality of serially coupled flip flop latches in response to a second control signal.

It is an advantage of the present invention to interface a microprocessor to a speakerphone. It is also an advantage of the present invention to provide a serial port interface in a speakerphone so that an increased number of modes of the speakerphone may be obtained while utilizing a minimum number of input data pins.

The above and other advantages and features of the present invention will be better understood from the following detailed description taken in conjunction with the accompanying drawings.

## Brief Description of the Drawings

FIG. 1 is a simplified partial block diagram illustrating a speakerphone using a serial port interface in accordance with the present invention; and.

FIG. 2 is a detailed block diagram illustrating a serial port interface in accordance with the present invention.

## Detailed Description of the Invention

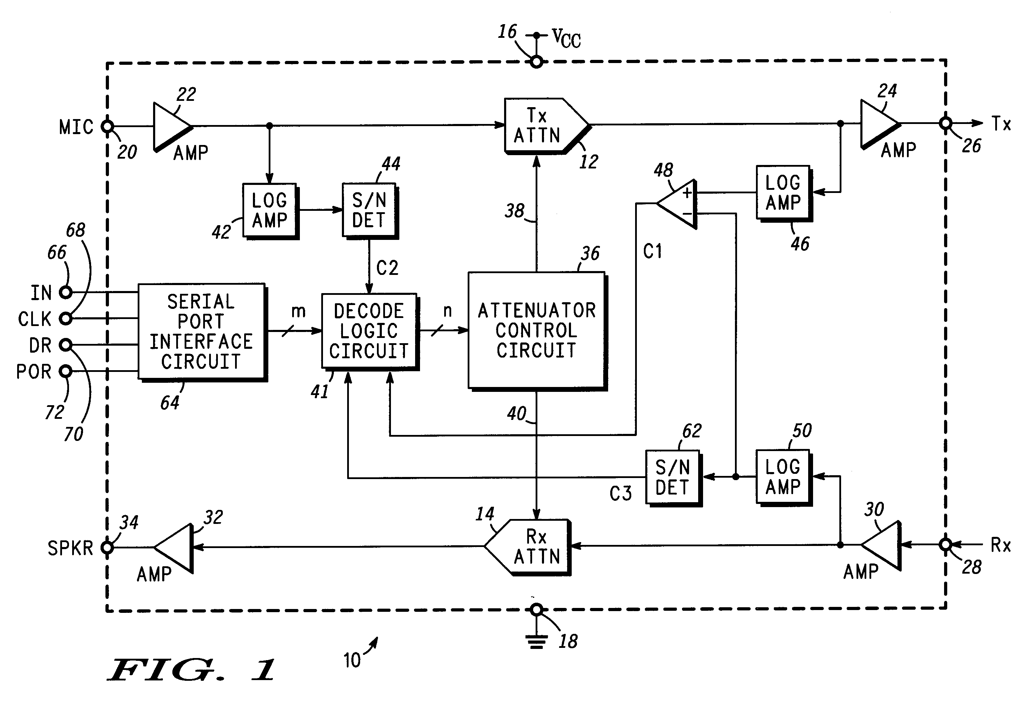

Referring to FIG. 1, there is illustrated a simplified partial block diagram of integrated speakerphone circuit 10 of the present invention. Speakerphone circuit 10 is voice-switched between a transmit (Tx) and a receive (Rx) mode in a half-duplex, hands free operation. Half-duplex operation is accomplished by controlling the gain/attenuation of attenuators 12 and 14. Attenuators 12 and 14 operate in a complementary manner, i.e., in response to a direct current (DC) control signal applied thereto the gain of one attenuator is maximized while the gain of the other is minimized. Power supply voltage $V_{CC}$ is applied across terminals 16 and 18. The transmit signal path which includes transmit attenuator 12 whereby the input of transmit attenuator 12 is coupled to input terminal 20 through amplifier 22. A microphone (not shown) would be connected to terminal 20. The output of transmit attenuator 12 is coupled to the transmit output terminal 26 through amplifier 24. The receive signal path includes receive attenuator 14 coupled in series between the output of amplifier 30 and the input of amplifier 32. The input of amplifier 30 is coupled to input terminal 28 while the output of amplifier 32 is coupled to output terminal 34. Output terminal 34 would be coupled to a speaker (not shown). Further, output terminal 26 and input terminal 28 would be coupled to the telephone lines via appropriate circuitry as understood. Attenuator control circuit 36 provides control voltages via voltage signal lines 38 and 40 to vary the gains respectively of attenuators 12 and 14 in response to logic signals C1, C2 and C3. Logic signals C1, C2 and C3 are decoded by decode logic circuit 41 to determine which channel, the transmit channel or the receive channel, has the largest signal appearing thereon and will be discussed in more detail hereinafter. At least one implementation for attenuator control circuit 36 is fully disclosed in US patent number 4,720,856, having an issue date of Jan. 19, 1988 and assigned to the same assignee of the subject application wherein the subject matter is incorporated herein by reference made thereto.

The output of amplifier 22 is sensed by logarithmic amplifier 42 and signal to noise detector 44 wherein logarithmic amplifier 42 provides a DC representation of a signal appearing at the output of amplifier 22. Signal C2 is forced to a logic high whenever the output of amplifier 22 is voice, otherwise signal C2 is a logic low. The transmit signal appearing at the output of transmit attenuator 12 is sensed via logarithmic amplifier 46 and compared with the receive signal appearing at the output amplifier 30 via logarithmic amplifier 50 wherein logarithmic amplifier 46 provides a DC representation of a signal appearing at the output of attenuator 12 while logarithmic amplifier 50 provides a DC representation of a signal appearing at the output of amplifier 30. The outputs of logarithmic amplifiers 46 and 50 are supplied to the non-inverting and inverting inputs respectively of comparator 48. If the DC representation of the transmit signal applied to comparator 48 is greater than the DC representation of the receive signal, then signal C1 will be forced to a logic high, otherwise signal C1 is a logic low. The output of comparator 48 supplies logic signal C1 to decode logic circuit 41. Further, the output of logarithmic amplifier 50 is sensed by signal to noise detector 62 to force signal C3 to a logic high whenever the output of amplifier 30 is voice, otherwise signal C3 is a logic low. Likewise, logic signal C3 is also supplied to decode logic circuit 41.

Speakerphone circuit 10 as so far described is similar to known prior art speakerphones, for instance the MC34018 speakerphone circuit manufactured by Motorola, Inc. Hence, if the near-end talker is speaking into the microphone and the far-end talker is listening, speakerphone 10 is placed in the Tx mode since signals C1 and C2 would be decoded by decode logic circuit 41 as both being in a logic high state. In the Tx mode, the voltage signals on lines 38 and 40 are set to maximize the gain of transmit attenuator 12 while the attenuation of receive attenuator 14 is maximized. Similarly, in response to a receive signal applied at input 28, speakerphone circuit 10 will be placed in a Rx mode since decode logic circuit 41 decodes signal C1 as being a logic low and C3 as being a logic high. Further, if neither talker is speaking, signals C2 and C3 are detected by decode logic circuit 41 as both being a logic low and, thus, speakerphone circuit 10 is placed in an idle mode wherein the gains of the two attenuators are adjusted to be substantially equal via lines 38 and 40. In the idle mode, no voice is detected on either channel, or speakerphone circuit 10 can not determine which signal, the transmit signal or the receive signal, is stronger. Thus, speakerphone circuit 10 waits for the next person to speak to determine the mode of operation.

Speakerphone circuit 10 also includes serial port interface (SPI) circuit 64 which has a plurality of inputs and provides a plurality of outputs, for example, 8, to decode logic circuit 41. A first input of SPI circuit 64 is coupled to terminal 66 at which signal IN (data input) is supplied. A second input of SPI circuit 64 is coupled to terminal 68 at which signal CLK (clock) is supplied. A third input of SPI circuit 64 is coupled to terminal 70 at which signal DR (data ready) is supplied. A fourth input of SPI circuit 64 is coupled to terminal 72 at which signal POR (power on reset) is supplied.

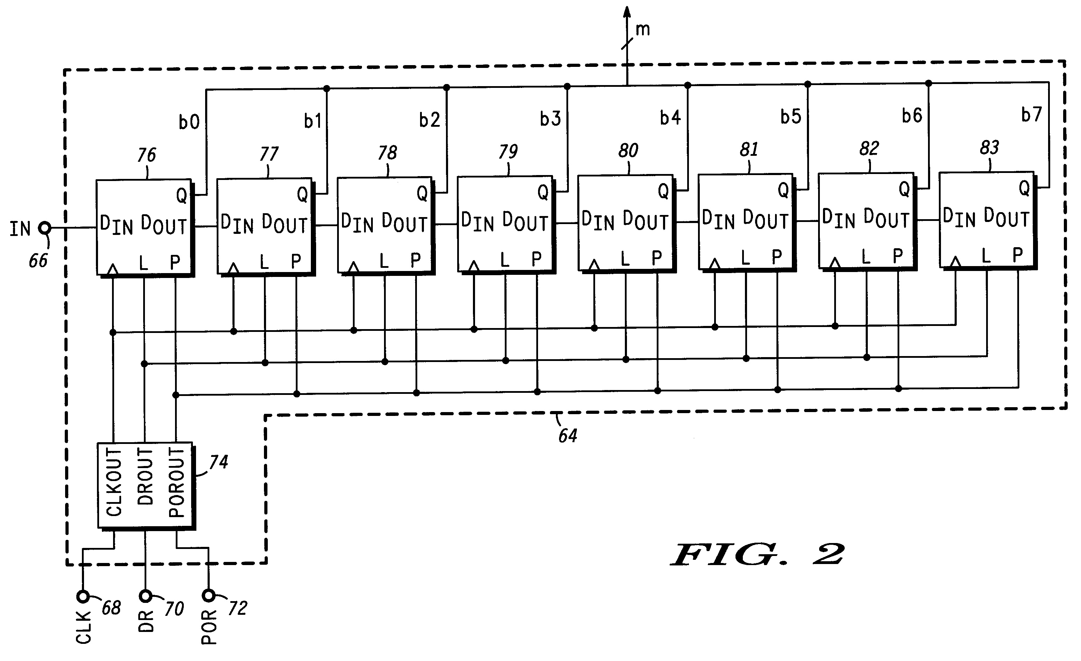

Referring to FIG. 2, a detailed block diagram of serial port interface (SPI) circuit 64 is shown. It is understood that components similar to those of FIG. 1 are designated by like reference numerals. SPI circuit 64 includes driver circuit 74 which has first, second and third inputs coupled respectively to terminals 68, 70 and 72. Driver circuit 74 also provides first, second and third outputs respectively denoted by CLKOUT, DROUT, and POROUT. It is understood that driver circuit 74 is primarily utilized to fan out signals CLK, DR and POR to flip-flop latches 76 through 83 whereby outputs CLKOUT, DROUT and POROUT correspond respectively to input signals CLK, DR and POR. It should also be undertstood that flip-flop latches 76 through 83 include both a flip-flop circuit and a latch circuit.

Flip-flop latch 76 has a data input ($D_{IN}$) coupled to terminal 66. The clock inputs of data latches 76-83 are coupled to receive signal CLK via the first output of driver circuit 74 while the latch input (denoted by L) of flip-flop latches 76 through 83 are coupled to receive signal DR via the second output of driver circuit 74. Likewise, the power on reset pin (denoted by P) of flip-flop latches 76 through 83 are coupled to receive signal POR via the third output of driver circuit 74. The middle flip-flop latches, flip-flop latches 77 through 82, are coupled such that the data input ($D_{IN}$) of each is coupled to the respective data output ($D_{OUT}$) of the previous adjacent flip-flop latch, while the data output of each flip-flop latch is coupled to the data input of the next succeeding adjacent flip-flop latch. For example, the data input of latch 77 is coupled to the data output of the previous adjacent latch, latch 76, while the data output of latch 77 is coupled to the next succeeding adjacent latch, latch 78. Further, flip-flop latch 83 has a data input coupled to the data output of flip-flop latch 82. The outputs (Q) of flip-flop latches 76 through 83 provide m outputs to decode logic circuit 41 where m is equal to the number of flip-flop latches. It is worth noting that flip-flop latches 76 through 83 include a D-type flip-flop circuit and a latch circuit wherein the D-type flip-flop circuit is responsive to signal CLK and the latch circuit is responsive to signal DR.

In the past, functions and modes, such as muting and volume control, of a speakerphone circuit have been done with parallel analog inputs. As a result, if there were N parallel analog inputs, then $2^N$ modes could be programmed into a speakerphone. On the other hand, SPI circuit 64 allows for inputting data serially into speakerphone circuit 10, even at high speeds, if desired. This data which is typically sent from a microprocessor (not shown) is input to speakerphone circuit 10 through a single input (at terminal 68).

In operation, data is serially shifted into a predetermined number of flip-flop latches, for example, 8, via terminals 66 and 68. That is, when signal CLK undergoes a first logic transition, for example, a logic low-to-high transition, the logic data appearing at terminal 66 is shifted into the flip-flop circuit of latch 76 via input $D_{IN}$. Likewise, since each latch is clocked by signal CLK, a first logic transition of signal CLK shifts data appearing at the data input of each flip-flop latch into the respective flip-flop latch. It is by this well known procedure that a predetermined bit-length word is loaded into flip-flop latches 76 through 83, as is understood. Once the respective bits have been shifted into flip-flop latches 76 through 83, a first logic transition of signal DR latches the data appearing in the flip-flop circuit of flip-flop latches 76 through 83 to their respective latch outputs (Q) as is understood. Further, the latch outputs of flip-flop latches 76 through 83 will remain stable and not change until the next first logic transition of signal DR. Therefore, a predetermined bit-length word which is equal to the number of flip-flop latches is provided at the output of SPI circuit 64, via signals b0-b7, which subsequently sends the data word to decode logic circuit 41. In addition, signal POR is utilized to program the outputs (Q) of flip-flop latches 76 through 83 to predetermined logic states at any time, for example, during power-up. Thus, signal POR can be used to temporarily disable SPI circuit 64 from speakerphone circuit 10 for any desired reason or until speakerphone circuit 10 is properly powered up.

Decode logic circuit 41 determines whether speakerphone circuit 10 should be in a transmit mode, a receive mode or an idle mode by decoding the logic levels of inputs signals C1, C2 and C3 as aforedescribed. In addition, it must be realized that the data word from the latch outputs (Q) of latches 76 through 83 contain information that is decoded by decode logic circuit 41 to determine additional modes or functions for speakerphone circuit 10. Some of these additional modes may include: forced receive mode, forced transmit mode, forced idle mode and volume control. Further, it must be realized that since the data word is m bits wide, where m is the number of flip-flop latches used in SPI circuit 64, there exists a possible $2^m$ modes that can be used to program speakerphone circuit 10. But, it must also be realized that although $2^m$ modes are available, only three input signals, IN, CLK and DR were required. As an example, for m = 8, $2^8$ or 256 modes are possible with the use of only three inputs. However, if parallel inputs were used, at least 8 inputs plus a clock input would be required. Thus, SPI circuit 64 provides a substantial increase in the programmability of speakerphone circuit 10 while utilizing a minimum number of inputs. This, of course, allows the package size of speakerphone circuit 10 to be kept small while still obtaining increased programmability. In addition, it is understood that SPI circuit 64 can be used to interface a speakerphone to a microprocessor.

By now it should be apparent that a novel speakerphone circuit has been provided which includes a serial port interface for interfacing a microprocessor to the speakerphone circuit.

## Claims

1. A serial port interface for a speakerphone, comprising a plurality of serially coupled flip-flop latches (76-83) having a data input coupled to receive a data logic signal and having a plurality of outputs for providing a plurality of output logic signals (60-67) to the speakerphone, said data logic signal being shifted into ones of said plurality of serially coupled flip flop latches in response to a first control signal (CLK) and subsequently appearing at said plurality of outputs of said plurality of serially coupled flip flop latches in response to a second control signal (DROUT).

2. The serial port interface according to claim 1 wherein each one of said plurality of serially coupled flip flop latches includes a clock input, a data input, a data output, a latch input and a latch output, said clock input of each one of said plurality of serially coupled flip flop latches being coupled to said first signal, said latch input of each one of said plurality of serially coupled flip flop latches being coupled to said second signal, said plurality of serially coupled flip-flop latches being coupled such that each one of said data outputs of said plurality of serially coupled flip-flop latches being coupled to said data input of a succeeding adjacent one of said plurality of serially coupled flip-flop latches, said latch outputs of each one of said plurality of serially coupled flip-flop latches providing said plurality of output signals.

3. An integrated speakerphone circuit having a transmit attenuator (12) in a transmit path, a receive attenuator (14) in a receive path, and a control circuit (36) for determining gains of the transmit and receive attenuators, comprising a serial port interface circuit (64) for receiving serial input data and for providing a plurality of output logic signals to the control circuit to program the integrated speakerphone circuit.

4. The integrated speakerphone circuit according to claim 3 wherein said serial port interface circuit includes a plurality of serially coupled flip-flop latches having a data input coupled to receive said serial input data and having a plurality of outputs for providing said plurality of output logic signals to the control circuit, said serial input data being shifted into ones of said plurality of serially coupled flip flop latches in response to a first control signal and subsequently appearing at said plurality of outputs of said plurality of serially coupled flip flop latches in response to a second control signal.

5. An integrated speakerphone circuit, comprising:

a transmit attenuator (12) coupled between a microphone input (20) and a transmit output (26) of a transmit path;

a receive attenuator (14) coupled between a receive input (28) and a speaker output (34) of a receive path;

a serial port interface circuit (64) for receiving serial input data and for providing a plurality of logic signals; and

a control circuit (36) responsive to said plurality of logic signals for programming the integrated speakerphone circuit.

6. The integrated speakerphone circuit according to claim 5 further including a decode logic circuit (41) coupled between said serial port interface circuit and said control circuit for decoding said plurality of logic signals from said serial port interface circuit to determine a mode of operation of the integrated speakerphone circuit.

**FIG. 1**

*FIG. 2*